# FASCICULE DE BREVET EUROPEEN

(11) **EP 1 883 954 B1**
(45) Date de publication et mention de la délivrance du brevet: **02.11.2011**
(21) Numéro de dépôt: 06808235.3
(22) Date de dépôt: 18.05.2006
(51) Int. Cl.: H01L 21/306, H01L 21/00

(54) **PROCEDE DE GRAVURE CHIMIQUE UNIFORME**
VERFAHREN ZUM GLEICHMÄSSIGEN CHEMISCHEN ÄTZEN
UNIFORM CHEMICAL ETCHING METHOD

(30) Priorité: 19.05.2005 FR 0505015
(43) Date de publication de la demande: 06.02.2008
(73) Titulaire: S.O.I.TEC Silicon on Insulator Technologies S.A., 38190 Bernin (FR)
(72) Inventeur: DELATTRE, Cécile, F-38660 Saint Hilaire Du Touvet (FR)
(74) Mandataire: Desormiere, Pierre-Louis
(86) Numéro de dépôt international: PCT/FR2006/050456
(87) Numéro de publication internationale: WO 2007/010149

(56) Documents cités:
- US-A1- 2002 026 985
- PATENT ABSTRACTS OF JAPAN vol. 2003, no. 12, 5 décembre 2003 (2003-12-05) & JP 2003 318154 A (DAINIPPON SCREEN MFG CO LTD), 7 novembre 2003 (2003-11-07)

## Description

### Domaine technique et art antérieur

La présente invention concerne la gravure chimique sélective des couches de surfaces de plaques, également dénommées "wafer", qui est mise en oeuvre notamment lors de la fabrication de plaques de type sSOI (silicium contraint sur isolant) ou de SGOI (silicium-germanium (SiGe) sur isolant). Dans la description qui suit, on utilise l'Angström (Å). Un Angström (1Å) équivaut à 0,1 nm.

Il existe plusieurs techniques d'élaboration pour de telles plaques. A titre d'exemple, l'une des plus performantes actuellement pour la fabrication de plaques de type sSOI ou SGOI est celle de la réalisation d'une couche active de silicium contraint (sSI en abrégé, pour "strained silicon") ou de SiGe relaxé par report de celle-ci sur un support isolant (par exemple couche de SiO₂ sur substrat de silicium), faisant intervenir la technologie Smart Cut™ pour réaliser l'hétérostructure désirée. Des exemples de mise en oeuvre de ces techniques de fabrication sont notamment décrits dans les documents US 2004/053477 et WO 2004/006311.

L'étape de finition de ces plaques fait intervenir un procédé de gravure sélective et éventuellement de polissage mécano-chimique pour éliminer la couche ou les couches de matériaux subsistant au-dessus de la couche de silicium après report de celle-ci sur le substrat "receveur" et séparation du substrat "donneur".

Par gravure sélective on entend ici le procédé d'attaque chimique qui permet d'éliminer de manière sélective, en jouant sur la composition de la solution chimique, la couche supérieure d'un matériau donné (couche de SiGe par exemple) sans attaquer la couche suivante (silicium contraint par exemple), appelée couche d'arrêt pour cette raison.

En raison de la finesse de la couche active de silicium contraint (de l'ordre de 200 Å), il est important de pouvoir contrôler avec une grande précision l'uniformité d'épaisseur de cette couche et la qualité de l'état de surface final. Cette exigence nécessite dans le cas présent d'optimiser le procédé de gravure sélective habituellement utilisé.

Pour le procédé usuel appelé "single wafer" (car traitant les plaquettes de manière individuelle et non collective), la gravure sélective se fait par dispense directe d'une solution chimique (mélange CH₃COOH/H₂O₂/HF) sur la surface de la plaque via une buse de dispense qui se déplace à partir du centre de la plaque sur un rayon de ± 40% du rayon total alors que la plaque est en rotation, ce qui entraîne une non-uniformité de la gravure : la partie centrale de la plaque est gravée plus profondément que le bord (phénomène caractérisé par le terme de "edge slow" pour ce type de gravure).

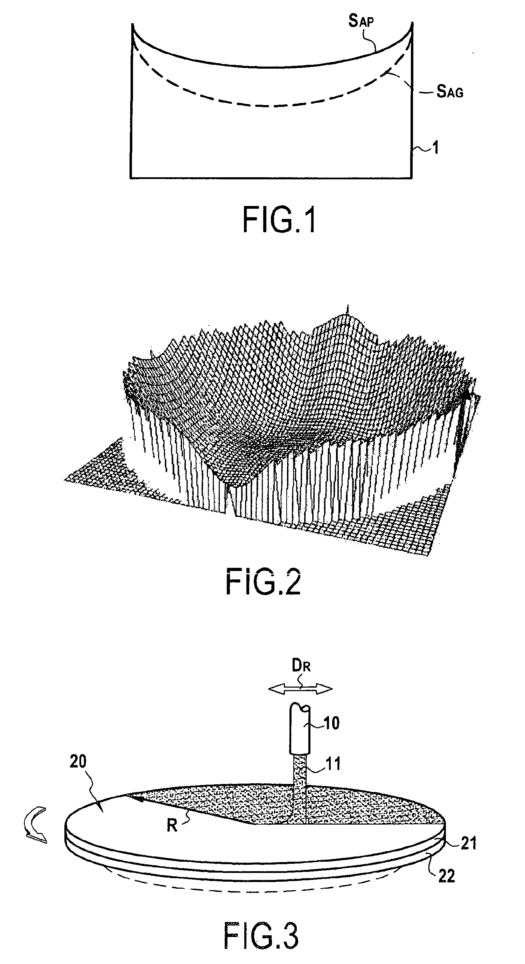

De la même façon le polissage effectué avant la gravure sélective, par exemple par polissage mécano-chimique CMP ("Chemical Mechanical Polishing"), a tendance à graver plus le centre que les bords de plaques comme représenté sur les figures 1 et 2 qui montrent l'état de surface d'une plaque de SiGe après polissage et gravure sélective. Sur la figure 1, la couche de SiGe 1 présente déjà en surface après le polissage une forme de "cuvette" (S_{AP}) qui s'accentue après la gravure sélective (S_{AG}). Sur la figure 2, on remarque la surgravure qui résulte au centre de la couche de SiGe par rapport aux bords de celle-ci.

Lorsque la plaque comprend une couche de silicium contraint sSi sous la couche de SiGe superficielle, le manque d'uniformité de la gravure (réalisée directement ou après polissage) entraîne une surgravure de la couche de sSi, située sous la couche de SiGe, au centre de la plaque, alors que des résidus de SiGe subsistent en bord de plaquette. On comprend donc que les enchaînements des étapes de CMP et de gravure sélective, ou une simple gravure sélective, ne peuvent pas conduire directement à une uniformité suffisante de l'épaisseur et de la rugosité de la couche de sSi mise à nue. Ce manque d'uniformité est particulièrement important pour des plaques de grands diamètres comme par exemple des plaques de 300 mm de diamètre.

Le document US-A-2002/026985 décrit un procédé de gravure chimique dans lequel l'agent de gravure est dispensé sous forme de jets au dessus d'un plaque en rotation. Ce procédé appartient à l'état de la technique relevant pour la présente invention.

### Résumé de l'invention

L'invention a pour but de remédier aux inconvénients précités et de proposer une solution qui permet de compenser les effets en bord de plaque de la gravure de type "edge slow" tout en limitant la surgravure au centre des plaques de manière à obtenir une gravure uniforme de la couche de SiGe.

Ce but est atteint avec un procédé de gravure chimique par voie humide de plaques comprenant au moins une couche superficielle en silicium-germanium (SiGe) destinée à être gravée par dispense d'une solution de gravure déposée sur la plaque en rotation, **caractérisé en ce qu'**il comprend une première étape de gravure dans laquelle ladite solution de gravure est dispensée à partir d'une position fixe située à une distance déterminée du centre de la plaque, et une seconde étape de gravure dans laquelle la solution de gravure est dispensée radialement à partir du centre de la plaque et sur une distance maximale inférieure au rayon de ladite plaque.

Ainsi, le procédé de l'invention permet, en mettant en oeuvre une étape supplémentaire de gravure dans laquelle la solution de gravure est dispensée à partir d'une position fixe à une distance déterminée du centre de la plaque, d'annihiler les effet de la gravure de type "edge slow" en compensant ses effets de faible gravure en bord de plaque. Cela permet d'obtenir non seulement une gravure chimique uniforme de la couche de SiGe mais aussi de conserver une surface hydrophile sur toute la plaque et ainsi d'éviter la formation de plots au centre de la plaque comme par exemple dans le cas d'une couche de SiGe (hydrophile) sur une couche de sSi (hydrophobe).

Dans le cas, par exemple, d'une plaque comprenant une couche de silicium contraint sous la couche de SiGe, dans la première étape de gravure, la solution de gravure peut être dispensée à partir d'une position fixe située à environ 50% du rayon de plaque, et, dans la seconde étape de gravure, la solution de gravure peut être dispensée sur une distance maximale correspondant à environ 40% du rayon de la plaque.

Les temps de gravure des première et seconde étape de gravure sont déterminés en fonction de:
- l'épaisseur de SiGe initiale à graver ;
- l'épaisseur du bord par rapport à l'épaisseur au centre de la plaque à graver par la première étape de gravure ;
- l'épaisseur du centre par rapport à l'épaisseur des bords de la plaque à graver par la seconde étape de gravure ;

La vitesse de rotation de la plaque peut-être comprise entre 400 tours/minute et 2000 tours/minute, par 1000 tours/minute.

Le temps de gravure de la première étape de gravure peut être environ 4 fois inférieur à celui de la second étape de gravure.

Le procédé peut comprendre en outre une étape de polissage mécano-chimique de la couche superficielle de SiGe réalisée avant les étapes de gravure. Dans ce cas, le temps de gravure de la première étape de gravure peut être d'environ 3,2 fois inférieur à celui de la seconde étape de gravure.

### Brève description des figures

- les figures 1 et 2, déjà décrites, sont respectivement une vue en coupe et une vue en perspective d'une couche de silicum-germanium après une gravure sélective,
- la figure 3 est une vue schématique en perspective montrant une étape de gravure sélective par dispense d'une solution de gravure sur une plaque en rotation conformément à un mode de mise en oeuvre de l'invention,
- la figure 4 montre les différents mouvements et positionnements d'une buse de dispense de solution de gravure,
- la figure 5 montre des profils de gravure d'une couche de SiGe en fonction de différents déplacements et/ou positionnements de la buse de dispense, et
- la figure 6 montre le profil de gravure d'une plaque après une étape de gravure avec buse en position fixe et après une étape de gravure avec buse en mouvement ainsi que le profil résultant après ces deux étapes.

### Exposé détaillé de modes de réalisation de l'invention

Le procédé de gravure de la présente invention s'applique d'une manière générale à la gravure de couche de silicium-germanium (SiGe). Ce procédé de gravure peut être utilisé pour graver la couche de SiGe:
- soit totalement pour découvrir, de la façon la plus uniforme possible, une couche inférieure, comme par exemple une couche de silicium contraint lors de la fabrication de structure de type SSOI, on parle alors de gravure sélective,
- soit partiellement pour réduire la rugosité de surface de la couche de SiGe par exemple.

La figure 3 illustre très schématiquement un mode de mise en oeuvre du procédé de gravure de l'invention appliquée à une gravure sélective d'une couche de SiGe vis-à-vis d'une couche de silicium contraint. Conformément à l'invention, on utilise un équipement de type "single wafer" par lequel la gravure sélective est réalisée par dispense directe d'une solution de gravure 11 sur une seule plaque 20 de rayon R et comprenant en surface une couche 21 de SiGe au dessus d'une couche de silicium contraint 22, la solution étant dispensée sur la plaque 20 en rotation par une buse 10. La buse 10 est reliée à un mécanisme (non représenté) permettant de déplacer cette dernière au dessus de la plaque 20 suivant une direction radiale D_{R}. La solution de gravure 11 est par exemple constituée d'un mélange bien connu d'acide acétique (CH₃COOH), d'eau oxygénée (H₂O₂) et d'acide fluorhydrique (HF).

Le procédé de gravure selon l'invention a pour but de compenser la gravure de type "edge slow" en ajoutant une étape complémentaire de gravure de type "edge fast" qui permet de corriger la faible gravure en bord de plaque et qui puisse annihiler au maximum la surgravure qui se fait au centre des plaques.

Afin d'optimiser les paramètres de la gravure de type "edge fast", des essais ont été menés en fonction de la position de la buse de dispense de la solution d'attaque chimique. Ces essais ont été effectués pour la gravure sélective d'une couche de SiGe située au-dessus de la couche active de silicium contraint comme représenté en figure 3.

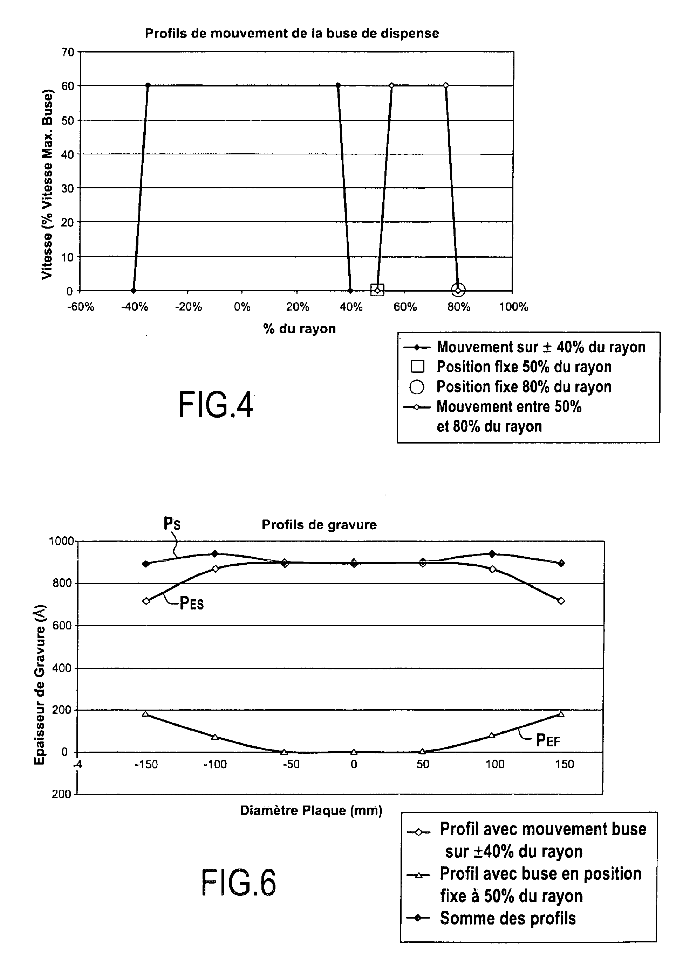

La figure 4 représente les profils de mouvement de la buse de dispense de solution de gravure placée verticalement au-dessus de la plaque (figure 3) suivant deux types de positionnent : soit suivant un positionnement fixe, soit suivant un mouvement de la buse selon une direction radiale par rapport à la plaque, la buse ayant un mouvement oscillant par rapport au centre de la plaque de manière à se déplacer d'un côté et de l'autre du centre de la plaque sur une distance équivalente. La vitesse indiquée sur la figure correspondant au pourcentage de la vitesse maximum de déplacement radial de la buse qui est ici de 130 mm/s.

En position fixe, la buse a été positionnée soit à 50% du rayon de la plaque à partir du centre, soit à 80%.

En mouvement, la buse a été centrée soit au milieu de la plaque, avec une amplitude de mouvement de ±40% du rayon, soit à 65% du rayon de la plaque à partir du centre, avec une amplitude de mouvement de ±15% correspondant à un déplacement entre 50% et 80% du rayon de la plaque.

Les résultats obtenus après gravure sélective, lorsque le bras a un mouvement non centré sur la plaque, montrent que la couche de silicium contraint finale au centre de la plaque est moins gravée que les bords, et présente alors un "plot" de silicium contraint. En effet, avec une position ou un mouvement non centré de la buse de dispense sur la plaque, la solution de gravure distribuée par la buse n'atteint plus le centre de la plaque quand la couche de silicium contraint est mise à nue car, de par sa nature hydrophobe, elle empêche la dispersion de la solution de gravure au centre de la plaque. Par conséquent, dans le cas d'une gravure sélective d'une couche de SiGe pour mettre à nu une couche de silicium contraint ou tout autre couche hydrophobe, l'étape de gravure type "edge fast" est réalisée avant l'étape de gravure de type "edge slow" dans laquelle la buse de dispense a un mouvement centré sur la plaque.

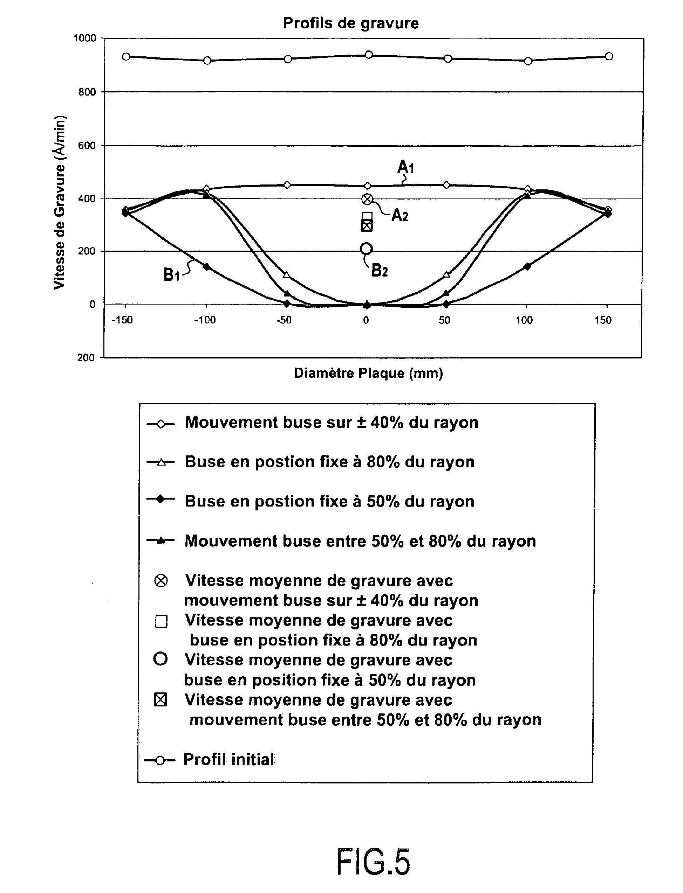

Les vitesses de gravure des surfaces de plaques de SiGe-silicium contraint (plaques de 300 mm de diamètre) ont été ensuite déterminées en fonction des différentes positions de la buse de distribution mentionnées ci-dessus. Elles sont indiquées sur la figure 5. La courbe située en haut de la figure 5 correspond au profil initial d'une plaque de SiGe-silicium contraint après polissage mais avant gravure sélective.

De l'analyse des résultats de la figure 5, on constate que lorsque la buse est décentrée il apparaît en général une ondulation d'épaisseur défavorable, sauf pour le cas de la position fixe à 50% du rayon, où la variation est régulière du centre au bord et inversée par rapport au cas de la buse oscillant à ±40% du rayon autour du centre.

L'analyse des courbes montre que pour les autres positions (i.e. buse en position fixe à 80% du rayon ou en mouvement entre 50% et 80% du rayon) de la buse de dispense, il y a apparition de bosses du fait d'une gravure très rapide au niveau de la buse, c'est-à-dire sur les bords, et très lente, voire inexistante, au centre de la plaque.

A partir de ces constatations, on définit la base du procédé de gravure objet de l'invention, à savoir combiner de manière appropriée une gravure de type "edge fast" (i.e. dispense de solution de gravure à partir de positions non centrées sur la plaque favorisant la gravure en bord de plaque) avec une gravure de type "edge slow" (i.e. dispense de solution de gravure à partir du centre de la plaque) pour améliorer l'uniformité de la gravure et, dans le cas d'une gravure sélective de plaques de SiGe-silicium contraint, réaliser la gravure de type "edge fast" avant celle de type "edge slow" pour conserver une surface hydrophile et ne pas générer de plots de silicium contraint au centre de la plaque.

Pour les essais réalisés ci-dessus, c'est-à-dire pour des plaques de SiGe-silicium contraint de diamètre de 300 mm, l'équipement de type "single wafer" (figure 3) doit être configuré pour permettre une gravure de type "edge fast" avec une buse de dispense située en position fixe à 50% du rayon de la plaque, cette première étape de gravure étant suivie d'une seconde étape de gravure de type "edge slow" dans laquelle la buse est en mouvement radial au-dessus de la plaque et se déplace alternativement de chaque côté du centre de la plaque sur une distance de ±40% du rayon de cette dernière.

La figure 6 illustre le profil de gravure d'une telle plaque après l'étape de gravure de type "edge fast" réalisée à partir d'une position fixe de la buse située à 50% du rayon de la plaque (courbe P_{EF}) et après l'étape de gravure de type "edge slow" avec mouvement de la buse à partir du centre de la plaque et sur une distance de 40% du rayon de celle-ci (courbe P_{ES}). La figure 6 montre en outre le profil résultant (courbe P_{S}) de la plaque après les deux étapes de gravure (la gravure "edge fast" étant ici réalisée avant la gravure "edge slow"). On peut observer que ce profil résultant correspondant est le complémentaire quasi-parfait du profil initial de la plaque représenté dans la figure 5, ce qui démontre que le procédé de l'invention permet non seulement d'obtenir une gravure uniforme de la couche de SiGe mais aussi de corriger les défauts d'uniformité initiaux présents à la surface de la couche de SiGe.

Les résultats obtenus sur la figure 5 ont permis de définir la position de la buse qui permet d'avoir le profil de gravure "edge fast" (courbe B₁) le mieux adapté pour compenser les effets de la gravure de type "edge slow" (courbe A₁). Toutefois, comme on peut le voir sur cette figure, les vitesses de gravure sont différentes entre ces deux types de gravure. Ces vitesses varient en fonction de l'endroit de la plaque considéré et en valeur moyenne (points A₂ et B₂). Par conséquent, il faut établir un rapport entre les temps de gravure de chaque étape ("edge fast" et "edge slow") qui permet d'avoir la compensation recherchée entre ces deux étapes.

Les temps de gravure sont en outre définis en prenant en compte les paramètres suivants:
- l'état de surface initial de la plaque après polissage, sachant que ce polissage est aussi de type "edge slow", c'est-à-dire provoque une surépaisseur en périphérie de la plaquette ;
- l'épaisseur de SiGe initiale à graver ;
- l'épaisseur du bord par rapport à l'épaisseur au centre à graver par une gravure type "edge fast" ;
- l'épaisseur du centre par rapport à l'épaisseur des bords à graver par une gravure du type "edge slow" ;

Ainsi, par exemple, pour une épaisseur de SiGe d'environ 900 Å à graver et pour une vitesse de rotation de la plaque d'environ 1000 tours/mn, 350 Å/mn sont consommés sur les bords par une gravure de type "edge fast" avec la buse de dispense de solution de gravure en position fixe à 50% du rayon de la plaque tandis que 88 Å/mn sont consommés au centre de la plaque par une gravure de type "edge slow" avec mouvement de la buse à partir du centre de la plaque et sur une distance de 40% du rayon de celle-ci.

On en déduit le rapport : 35/8,8 = 4 pour les temps de gravure respectifs entre les deux étapes.

Ainsi, si l'étape de gravure "edge slow" est de 160 s, alors l'étape de type "edge fast" sera de 160/4= 40 s.

De plus si une étape de polissage est réalisée, créant une surépaisseur de bord d'environ 22 Å, il faut prolonger d'environ 10 s l'étape de gravure de type "edge fast", soit un temps total de 50 s pour cette étape.

Les avantages résultant de ce nouveau procédé sont une meilleure qualité de la couche de silicium contraint, à savoir en uniformité d'épaisseur et rugosité de surface, et une meilleure reproductibilité du processus de gravure.

Bien que les exemples ci-dessus sont décrits en relation avec des plaques comportant une couche SiGe recouvrant une couche de silicium contraint qui doit être mise à nue par gravure sélective de la couche de SiGe, la présente invention peut s'appliquer de la même façon que décrit précédemment à une plaque ayant une couche de SiGe qui doit être gravée que partiellement. En effet, le procédé de l'invention peut très bien être mis en oeuvre pour graver uniformément une partie seulement de la couche de SiGe dans le but, par exemple, de réduire sa rugosité.

## Revendications

1. Procédé de gravure chimique par voie humide d'une plaque (20) comprenant au moins une couche superficielle en silicium-germanium (SiGe) (21) destinée à être gravée par dispense d'une solution de gravure (11) déposée sur la plaque en rotation, **caractérisé en ce qu'**il comprend une première étape de gravure dans laquelle ladite solution de gravure (11) est dispensée à partir d'une position fixe située à une distance déterminée du centre de la plaque, et une seconde étape de gravure dans laquelle la solution de gravure (11) est dispensée radialement à partir du centre de la plaque et sur une distance maximale inférieure au rayon (R) de ladite plaque.

2. Procédé de gravure selon la revendication 1, **caractérisé en ce que** la plaque comprend une couche de silicium contraint (22) sous la couche de SiGe (21) et **en ce que**, dans la première étape de gravure, la solution de gravure (11) est dispensée à partir d'une position fixe située à environ 50% du rayon de plaque, et **en ce que**, dans la seconde étape de gravure, la solution de gravure (11) est dispensée sur une distance maximale correspondant à environ 40% du rayon de la plaque.

3. Procédé selon la revendication 2, **caractérisé en ce que** le temps de gravure de la première étape gravure est environ 4 fois inférieur à celui de la seconde étape de gravure.

4. Procédé selon la revendication 2, **caractérisé en ce qu'**il comprend en outre une étape de polissage mécano-chimique de la couche superficielle de SiGe (21) réalisée avant lesdites première et seconde étapes de gravure, le temps de gravure de la première étape de gravure est environ 3,2 fois inférieur à celui de la seconde étape de gravure.

5. Procédé selon l'une quelconque des revendications 1 à 4, **caractérisé en ce que** les temps de gravure des première et seconde étape de gravure sont déterminés en fonction de:
- l'épaisseur de SiGe initiale à graver ;
- l'épaisseur du bord par rapport à l'épaisseur au centre de la plaque à graver par la première étape de gravure ;
- l'épaisseur du centre par rapport à l'épaisseur des bords de la plaque à graver par la seconde étape de gravure ;

6. Procédé selon l'une quelconque des revendications 1 à 5, **caractérisé en ce que** la plaque (20) a un diamètre de 300 mm.

7. Procédé selon l'une quelconque des revendications 1 à 6, **caractérisé en ce que** la solution de gravure (11) comprend un mélange d'acide acétique (CH₃COOH), d'eau oxygénée (H₂O₂) et d'acide fluorhydrique (HF).

8. Procédé selon l'une quelconque des revendications 1 à 3, **caractérisée en ce que** la vitesse de rotation de la plaque est comprise entre 400 tours/minute et 2000 tours/minute.

## Claims

1. A method of wet chemical etching of a wafer (20) comprising at least one surface layer of silicon-germanium (SiGe) (21) for etching by dispensing an etching solution (11) deposited on a rotating wafer, the method being **characterized in that** it comprises a first etching step in which said etching solution (11) is dispensed from a fixed position located at a predetermined distance from the center of the wafer, and a second etching step in which the etching solution (11) is dispensed radially from the center of the wafer and over a maximum distance which is less than the radius (R) of said wafer.

2. An etching method according to claim 1, **characterized in that** the wafer comprises a layer of strained silicon (22) beneath the layer of SiGe (21) and **in that**, in the first etching step, the etching solution (11) is dispensed from a fixed position located at about 50% of the radius of the wafer and **in that** in the second etching step, the etching solution (11) is dispensed over a maximum distance corresponding to about 40% of the radius of the wafer.

3. A method according to claim 2, **characterized in that** the etching period for the first etching step is about 4 times shorter than that for the first etching step.

4. A method according to claim 2, **characterized in that** it further comprises a step of chemical-mechanical polishing of the superficial SiGe layer (21) carried out prior to said first and second etching steps, the etching period for the first etching step being about 3.2 times shorter than that for the second etching step.

5. A method according to any one of claims 1 to 4, **characterized in that** the etching period for the first and second etching steps are determined as a function of:
- the initial thickness of SiGe to be etched;
- the thickness at the edge compared with the thickness at the center of the wafer to be etched by the first etching step;
- the thickness at the center compared with the thickness at the edges of the wafer to be etched by the second etching step.

6. A method according to any one of claims 1 to 5, **characterized in that** the diameter of the wafer (20) is 300 mm.

7. A method according to any one of claims 1 to 6, **characterized in that** the etching solution (11) comprises a mixture of acetic acid (CH₃COOH), hydrogen peroxide (H₂O₂) and hydrofluoric acid (HF).

8. A method according to any one of claims 1 to 3, **characterized in that** the rotation rate of the wafer is in the range 400 rpm to 2000 rpm.

## Patentansprüche

1. Verfahren zum naßchemischen Ätzen einer Scheibe (20), die wenigstens eine Oberflächenschicht aus Silizium-Germanium (SiGe) (21) umfaßt, welche dazu bestimmt ist, durch Verteilen einer Ätzlösung (11), die auf der sich drehenden Scheibe abgeschieden wird, geätzt zu werden, **dadurch gekennzeichnet, daß** es einen ersten Ätzschritt, bei dem die Ätzlösung (11) von einer in einem bestimmen Abstand vom Mittelpunkt der Scheibe befindlichen festen Position aus verteilt wird, und einen zweiten Ätzschritt umfaßt, bei dem die Ätzlösung (11) vom Mittelpunkt der Scheibe aus und über eine maximale Strecke, die kleiner als der Radius (R) der Scheibe ist, radial verteilt wird.

2. Ätzverfahren nach Anspruch 1, **dadurch gekennzeichnet, daß** die Scheibe einen Schicht aus gespanntem Silizium (22) unter der SiGe-Schicht (21) umfaßt und daß in dem ersten Ätzschritt die Ätzlösung (11) von einer bei etwa 50 % des Scheibenradius befindlichen Position aus verteilt wird und daß in dem zweiten Ätzschritt die Ätzlösung (11) über eine maximale Strecke, die etwa 40 % des Radius der Scheibe entspricht, verteilt wird.

3. Verfahren nach Anspruch 2, **dadurch gekennzeichnet, daß** die Ätzzeit des ersten Ätzschrittes etwa viermal geringer als die des zweiten Ätzschrittes ist.

4. Verfahren nach Anspruch 2, **dadurch gekennzeichnet, daß** es ferner einen chemisch-mechanischen Polierschritt der SiGe-Oberflächenschicht (21) umfaßt, der vor dem ersten und dem zweiten Ätzschritt durchgeführt wird, die Ätzzeit des ersten Ätzschrittes etwa 3,2-mal geringer als die des zweiten Ätzschrittes ist.

5. Verfahren nach einem der Ansprüche 1 bis 4, **dadurch gekennzeichnet, daß** die Ätzzeiten des ersten und des zweiten Ätzschrittes bestimmt werden in Abhängigkeit von:
- der zu ätzenden SiGe-Anfangsdicke,
- der Dicke der Kante gegenüber der Dicke des Mittelpunktes der Scheibe, die mittels des ersten Ätzschrittes zu ätzen ist,
- der Dicke des Mittelpunktes gegenüber der Dicke der Kanten der Scheibe, die mittels des zweiten Ätzschrittes zu ätzen ist.

6. Verfahren nach einem der Ansprüche 1 bis 5, **dadurch gekennzeichnet, daß** die Scheibe (20) einen Durchmesser von 300 mm aufweist.

7. Verfahren nach einem der Ansprüche 1 bis 6, **dadurch gekennzeichnet, daß** die Ätzlösung (11) ein Gemisch aus Essigsäure (CH₃COOH), aus Wasserstoffperoxid (H₂O₂) und aus Flußsäure (HF) umfaßt.

8. Verfahren nach einem der Ansprüche 1 bis 3, **dadurch gekennzeichnet, daß** die Rotationsgeschwindigkeit der Schreibe zwischen 400 Umdrehungen/Minute und 2000 Umdrehungen/Minute liegt.
